# EUROPEAN PATENT APPLICATION

(11) **EP 4 676 190 A1**
(43) Date of publication of application: **07.01.2026**
(21) Application number: 24909459.0
(22) Date of filing: 11.04.2024
(51) Int. Cl.: H10F 19/80, H10F 19/90, H02S 20/25

(54) **CURVED PHOTOVOLTAIC PART AND PHOTOVOLTAIC BUILDING SURFACE**

(30) Priority: 25.12.2023 CN 202323572059 U
(71) Applicant: Shenzhen Hello Tech Energy Co., Ltd, Shenzhen, Guangdong 518109 (CN)
(72) Inventor: YU, Huajun, Shenzhen, Guangdong 518109 (CN); ZHU, Yanjun, Shenzhen, Guangdong 518109 (CN); SUN, Zhongwei, Shenzhen, Guangdong 518109 (CN); FU, Rao, Shenzhen, Guangdong 518109 (CN); LAI, Huilong, Shenzhen, Guangdong 518109 (CN); FAN, Dengfeng, Shenzhen, Guangdong 518109 (CN); ZHANG, Jie, Shenzhen, Guangdong 518109 (CN)
(74) Representative: Dehns Germany Partnerschaft mbB
(86) International application number: PCT/CN2024/087300
(87) International publication number: WO 2025/138490

(57) **Abstract**

A curved photovoltaic module (100) includes a battery string (10). Each battery string (10) includes a plurality of battery cells (11) connected in series and arranged in a first direction of the curved photovoltaic module (100). The curved photovoltaic module (100) has at least one crest (101) and at least one trough (103). In the first direction, each battery cell (11) in each of the at least one battery string (10) covers a corresponding crest (101) and is symmetrically arranged about an axis of the corresponding crest (11) that extends in the first direction.

## Description

### PRIORITY INFORMATION

This application claims priority and benefit from Chinese Patent Application No. 202323572059.1, filed with China National Intellectual Property Administration on December 25, 2023, which is incorporated herein by reference in its entirety.

### FIELD

The present disclosure relates to the field of photovoltaic technologies, and more particularly, to a curved photovoltaic module and a photovoltaic building surface.

### BACKGROUND

With the increasing popularity of building integrated photovoltaics, a photovoltaic module (photovoltaic tile) that can replace a traditional tile has emerged, for better comination with the building surface. The photovoltaic module may be either a flat photovoltaic module or a curved photovoltaic module. Compared to the flat photovoltaic module, the curved photovoltaic module is aesthetically pleasing and has the power generation function due to its unique shape. Currently, the curved photovoltaic module generally includes one or more battery strings, each battery string is formed by a plurality of battery cells connected in series. However, since the plurality of battery cells in one battery string are distributed at different positions of the curved photovoltaic module, light intensities received by the plurality of battery cells in the battery string at the same time are different. A battery cell that receives a small light intensity generates a small current, which lowers the output current of the battery string.

### SUMMARY

Embodiments of the present disclosure provide a curved photovoltaic module and a photovoltaic building surface, at least for solving a problem that light intensities received by a plurality of battery cells in a battery string at the same time are different, and a battery cell that receive a small light intensity generates a small current, which lowers the output current of the battery string.

The curved photovoltaic module of the embodiments of the present disclosure includes at least one battery string. Each of the at least one battery string includes a plurality of battery cells connected in series and arranged in a first direction of the curved photovoltaic module. The curved photovoltaic module has at least one crest and at least one trough. In the first direction, where each of the plurality of battery cells in each of the at least one battery string covers a corresponding crest of the at least one crest and is symmetrically arranged about an axis of the corresponding crest that extends in the first direction.

**In** some embodiments, in a second direction, each of the plurality of battery cells has opposite ends each extending towards a lowest point of an adjacent trough of the at least one trough. The second direction is an extending direction of a tangent at a highest point of the corresponding crest, and the second direction intersects with the first direction.

**In** some embodiments, the at least one battery string includes a plurality of battery strings, and two adjacent battery strings of the plurality of battery strings are spaced apart from each other by a spacing in the second direction. The spacing has a width in a range of [3 mm, 5 mm].

**In** some embodiments, a difference in light intensities received by any two of the plurality of battery cells in each of the at least one battery string is within a predetermined range.

**In** some embodiments, the curved photovoltaic module has a ratio of an arc length to a chord length in a range of [1.03, 1.06].

**In** some embodiments, a length of each of the plurality of battery cells in the second direction has a positive correlation with a tolerable deformation of the battery cell when the battery cell is bent conformally.

In some embodiments, a thickness of each of the plurality of battery cells has a negative correlation with the tolerable deformation of the battery cell when the battery cell is bent conformally.

In some embodiments, the length of each of the plurality of battery cells in the second direction has a positive correlation with a tolerable deformation of the battery cell when the battery cell is bent conformally, and the thickness of each of the plurality of battery cells has a negative correlation with the tolerable deformation of the battery cell when the battery cell is bent conformally.

In some embodiments, the curved photovoltaic module further includes a front plate and a back plate. The front plate, the at least one battery string, and the back plate are sequentially stacked.

In some embodiments, the front plate is a curved front plate. The at least one battery string is bent conformally with the front plate. An arch height of the front plate is smaller than or equal to a maximum tolerable deformation of the battery cell when the battery cell is bent conformally.

In some embodiments, the back plate is a curved back plate. The at least one battery string is bent conformally with the back plate. An arch height of the back plate is smaller than or equal to a maximum tolerable deformation of the battery cell when the battery cell is bent conformally.

In some embodiments, the front plate is the curved front plate. The at least one battery string is bent conformally with the front plate. The arch height of the front plate is smaller than or equal to the maximum tolerable deformation of the battery cell when the battery cell is bent conformally. The back plate is the curved back plate. The at least one battery string is bent conformally with the back plate. The arch height of the back plate is smaller than or equal to the maximum tolerable deformation of the battery cell when the battery cell is bent conformally.

In some embodiments, the curved photovoltaic module further includes an adhesive film layer configured to bond the front plate with the at least one battery string and bond the at least one battery string with the back plate.

The photovoltaic building surface of the embodiments of the present disclosure includes the curved photovoltaic module described in the above embodiments.

In the curved photovoltaic module and the photovoltaic building surface of the embodiments of the present disclosure, the plurality of battery cells of the battery string is arranged in the first direction of the curved photovoltaic module. Each battery cell in the battery string covers the corresponding crest, and is symmetrically arranged about an axis of the corresponding crest that extends in the first direction. Therefore, light intensities received by the plurality of battery cells are substantially the same in a same time period, and the battery string can output a large current. Compared with the conventional curved photovoltaic module, since the light intensities received by the plurality of battery cells in the battery string of the present disclosure are substantially the same, the problem that the battery cell receiving a small light intensity in the battery string generates a small current and lowers the output current of the battery string can be avoided.

Additional aspects and advantages of the present disclosure will be given at least in part in the following description, or will become apparent at least in part from the following description, or can be learned from practicing of the present disclosure.

### BRIEF DESCRIPTION OF THE DRAWINGS

The above and/or additional aspects and advantages of the present disclosure will become apparent and more understandable from the following description of embodiments taken in conjunction with the accompanying drawings.
FIG. 1 is a schematic three-dimensional view of a battery string and a back plate according to some embodiments of the present disclosure.
FIG. 2 is a schematic view of a structure of the battery string and the back plate of FIG. 1.
FIG. 3 is a schematic view of a structure of the battery string and the back plate of FIG. 1.
FIG. 4 is a schematic three-dimensional exploded view of a curved photovoltaic module according to some embodiments of the present disclosure.
FIG. 5 is a schematic three-dimensional view of a photovoltaic building surface according to some embodiments of the present disclosure.

### DETAILED DESCRIPTION

To make the above-mentioned objects, features, and advantages of the present disclosure more obvious and comprehensive, a detailed description of specific embodiments of the present disclosure will be given below in conjunction with the accompanying drawings. In the following description, many specific details are provided to facilitate a full understanding of the present disclosure. However, the present disclosure can be implemented in many different forms, and similar improvements can be made by those skilled in the art without contradicting the intent of the present disclosure. Therefore, the present disclosure is not limited by specific embodiments disclosed below.

In descriptions of the present disclosure, it should be understood that the orientation or the position indicated by terms such as "center", "longitudinal", "lateral", "length", "width", "thickness", "over", "below", "front", "rear", "left", "right", "vertical", "horizontal", "top", "bottom", "inner", "outer", "clockwise", "anti-clockwise", "axial", "radial", and "circumferential" should be construed to refer to the orientation and the position as shown in the drawings in discussion, and is only for the convenience of describing the present disclosure and simplifying the description, rather than indicating or implying that the pointed device or element must have a specific orientation, or be constructed and operated in a specific orientation, and therefore cannot be understood as a limitation of the present disclosure.

In addition, terms "first" and "second" are only used for descriptive purposes, and cannot be understood as indicating or implying relative importance or implicitly indicating the number of the indicated technical features. Therefore, the features associated with "first" and "second" may explicitly or implicitly include at least one of the features. In the description of the present disclosure, "plurality" means at least two, unless otherwise specifically defined.

In the present disclosure, unless otherwise clearly specified and limited, terms such as "install", "connect", "connect to", "fix" and the like should be understood in a broad sense. For example, it may be a fixed connection or a detachable connection or connection as one piece; mechanical connection or electrical connection; direct connection or indirect connection through an intermediate; internal communication of two elements or the interaction relationship between two elements, unless otherwise clearly limited. For those skilled in the art, the specific meaning of the above-mentioned terms in the present disclosure can be understood according to specific circumstances.

In the present disclosure, unless expressly stipulated and defined otherwise, the first feature "on" or "under" the second feature may mean that the first feature is in direct contact with the second feature, or the first and second features are in indirect contact through an intermediate. Moreover, the first feature "above" the second feature may mean that the first feature is directly above or obliquely above the second feature, or simply mean that the level of the first feature is higher than that of the second feature. The first feature "below" the second feature may mean that the first feature is directly below or obliquely below the second feature, or simply mean that the level of the first feature is smaller than that of the second feature.

It should be noted that when an element is said to be "fixed to" or "disposed at" another element, it may be directly on the other element or there may be an intermediate element. When an element is considered to be "connected to" another element, it may be directly connected to the other element or there may be an intermediate element. The terms "vertical", "horizontal", "upper", "lower", "left", "right", and the like are used herein for illustrative purposes only and are not meant to be the only implementation.

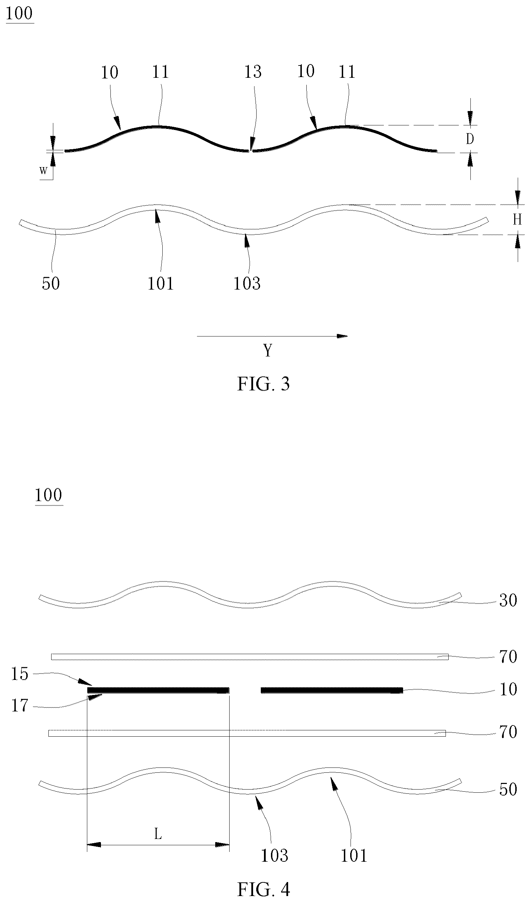

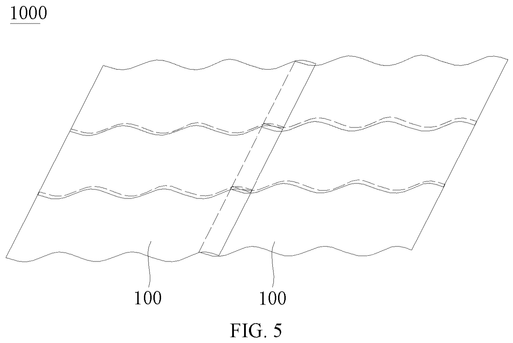

With the increasing popularity of building integrated photovoltaics, a photovoltaic module (photovoltaic tile) that can replace a traditional tile has emerged, for better comination with the building surface. The photovoltaic module may be either a flat photovoltaic module or a curved photovoltaic module. Compared to the flat photovoltaic module, the curved photovoltaic module, that can replace the traditional tile due to its unique shape, is aesthetically pleasing and has the power generation function. Currently, the curved photovoltaic module generally includes one or more battery strings, each battery string is formed by a plurality of battery cells connected in series. However, since the plurality of battery cells in one battery string are distributed at different positions of the curved photovoltaic module, light intensities received by the plurality of battery cells in the battery string at the same time are different. A battery cell that receives a small light intensity generates a small current, which lowers the output current of the battery string. To solve this problem, a curved photovoltaic module 100 (shown in FIG. 4) and a photovoltaic building surface 1000 (shown in FIG. 5) are provided according to the embodiments of the present disclosure.

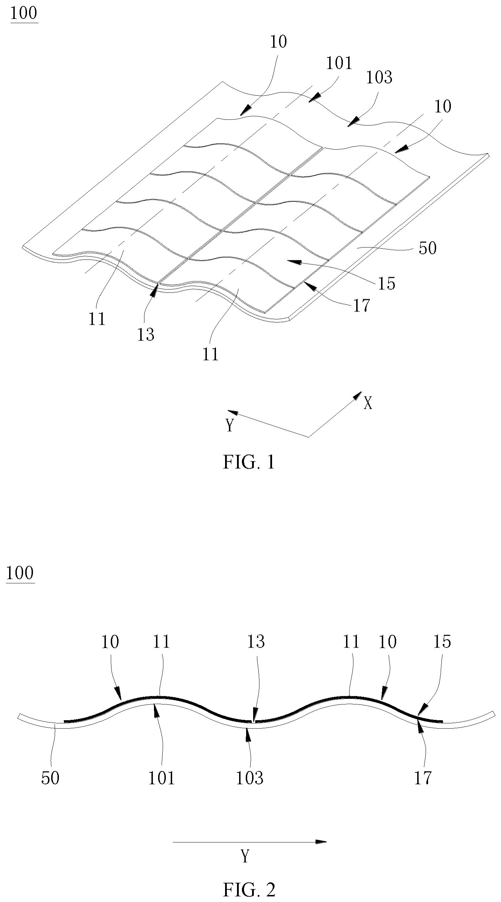

Referring to FIG. 1, a curved photovoltaic module 100 according to an embodiment of the present disclosure includes at least one battery string 10. The battery string 10 includes a plurality of battery cells 11 connected in series and arranged in a first direction X of the curved photovoltaic module 100. The curved photovoltaic module 100 has at least one crest 101 and at least one trough 103. In the first direction X, each battery cell 11 in one battery string 10 covers a corresponding crest 101 and is symmetrically arranged about an axis of the corresponding crest 101 that extends in the first direction X.

In an embodiment of the present disclosure, the curved photovoltaic module 100 is configured to convert light energy into electric energy to supply power to other elements, and may be used as a structural component of a building. For example, the curved photovoltaic module 100 may supply power to a household appliance, an energy storage power supply, or a street lamp. The curved photovoltaic module 100 can generate electric energy while maintaining the aesthetics of the building.

Referring to FIG. 1, the battery string 10 is configured to receive light energy and convert the light energy into electric energy. The battery string 10 can input the generated electric energy to other circuits to allow the curved photovoltaic module 100 to supply power to other elements. The battery string 10 includes a light-receiving surface 15 and a back surface 17. Light enters the battery string 10 from the light-receiving surface 15 of the battery string 10. The curved photovoltaic module 100 may include one, two, three, four, or more battery strings 10. When one battery string 10 is included, electric energy generated by the battery string 10 is outputted to supply power to other elements. When a plurality of battery strings 10 are included, the plurality of battery strings 10 is connected in parallel and/or in series to output the generated electric energy to supply power to other elements. In an embodiment, the plurality of battery strings 10 are connected in parallel. In this case, the curved photovoltaic module 100 outputs a large current. In another example, the plurality of battery strings 10 are connected in series. In this case, the curved photovoltaic module 100 outputs a high voltage.

Referring to FIG. 1, one battery string 10 may include two, three, four, or more battery cells 11 that are connected in series to form a series circuit. The battery cell 11 is configured to receive light energy and convert the light energy into electric energy. A positive electrode and a negative electrode of the battery cell 11 may be provided at the light-receiving surface 15 and the back surface 17, respectively, or both the positive electrode and the negative electrode of the battery cell 11 may be provided at the back surface 17. In an embodiment, the positive electrode and the negative electrode of the battery cell 11 are provided at the light-receiving surface 15 and the back surface 17, respectively. In this case, the battery cell 11 may be a Passivated Emitter and Rear Cell (PERC) or a Tunnel Oxide Passivating Contact (TOPCON) cell. In another embodiment, the positive electrode and the negative electrode of the battery cell 11 are both provided at the back surface 17. In this case, the battery cell 11 may be an Interdigitated Back Contact (IBC) cell, an All Back Contact (ABC) cell, a Hybrid Passivated Back Contact (HPBC) cell, or a Metallization Wrap-through (MWT) cell.

Referring to FIG. 1, the number of crests 101 of the curved photovoltaic module 100 may be, but is not limited to, one, two, three, four, or more. The number of troughs 103 of the curved photovoltaic module 100 may be, but is not limited to, one, two, three, four, or more. The number of crests 101 may be the same as or different from the number of troughs 103. For example, when two crests 101 are provided, the number of troughs 103 may be one, two, or three. When three crests 101 are provided, the number of troughs 103 may be two, three, or four. A radius of the crest 101 may be the same as or different from a radius of the trough 103.

At present, battery strings in most curved photovoltaic modules may be arranged in the following manner. A plurality of battery cells of one battery string is arranged in a second direction. In this case, the plurality of battery cells in the battery string may be arranged at the crest and the trough. For example, the crest includes a highest point and opposite sides connected to the highest point. Battery cell A, battery cell B, and battery cell C are respectively distributed at one side of the crest, the highest point of the crest, and the other side of the crest. During the same period, light intensities received by the battery cell A, the battery cell B, and the battery cell C are different. When the light intensity received by the battery cell A is highest, the battery cell A generates a current a. In this case, the light intensity received by the battery cell B is second-highest, and the battery cell B generates a current b. The light intensity received by the battery cell C is lowest, and the battery cell C generates a current c. Magnitudes of the currents generated by the three battery cells satisfy: a>b>c. Since the battery string is a series circuit, the current outputted by the battery string is c, and the current outputted by the battery string as a whole is small.

Referring to FIG. 1, each battery cell 11 in the battery string 10 of the present disclosure covers a corresponding crest 101. When the battery cell 11 covers the corresponding crest 101, a surface of the battery cell 11 is not blocked, and the light intensity received by the battery cell 11 is relatively large. In this way, the battery cell 11 can generate a large current, and the output current of the battery string 10 is relatively large. Preferably, each battery cell 11 is symmetrically arranged about the axis of the corresponding crest 101 that extends in the first direction X. The battery cell 11 can receive a certain light intensity at different solar incidence angles on the curved photovoltaic module 100 in different time periods. In addition, a difference between the light intensities received by the battery cell 11 in different time periods is small, allowing the battery string 10 to output a stable current in different time periods (the magnitude of the output current does not change greatly with the change of time). The case that one battery cell 11 in the battery string 10 generates a current which is much smaller than currents generated by the other battery cells 11, which lowers the output current of the battery string 10, can be avoided.

Further, since each battery cell 11 is arranged at the crest 101 in the first direction X, when the curved photovoltaic module 100 is assembled, the battery cell 11 needs to be bent conformally to fit the crest 101 of a front plate 30 and/or a back plate 50 (shown in FIG. 4) of the curved photovoltaic module 100, resulting in a relatively large deformation of the battery cells 11. When the battery cell 11 is symmetrically arranged about the axis of the corresponding crest 101 that extends in the first direction X, in the first direction X, forces on the left and right sides of the battery cell 11 during bending deformation are relatively uniform, and thus the battery cell 11 is not easily broken during the deformation process. In addition, a maximum tolerable deformation of the battery cell 11 when the battery cell 11 is bent conformally at the crest 101 is greater than a maximum tolerable deformation of the same battery cell 11 when the battery cell 11 is bent conformally at the trough 103. Therefore, when the battery cell 11 covers the crest 101, a tolerable deformation D of the battery cell 11 is relatively large, thus the battery cell 11 is not easily broken.

In the curved photovoltaic module 100 of the embodiments of the present disclosure, the plurality of battery cells 11 of the battery string 10 is arranged in the first direction X of the curved photovoltaic module 100. Each of the battery cells 11 in the battery string 10 covers a corresponding crest 101, and is symmetrically arranged about the axis of the corresponding crest 101 that extends in the first direction X. Therefore, light intensities received by the plurality of battery cells 11 are substantially the same in the same period, and the battery string 10 outputs a large current. Compared with the existing curved photovoltaic module 100, since the light intensities received by the plurality of battery cells 11 in the battery string 10 of the present disclosure are substantially the same, the problem that the battery cell 11 receiving the small light intensity in the battery string 10 generates small current and this battery cell 11 lowers the output current of the battery string 10 can be avoided.

The curved photovoltaic module 100 is further described below in conjunction with the accompanying drawings.

Referring to FIG. 1 and FIG. 2, further, in some embodiments, in a second direction Y, the battery cell 11 has opposite ends each extending towards a lowest point of an adjacent trough 103. The second direction is an extending direction of a tangent at the highest point of the corresponding crest, and the second direction intersects with the first direction. In an embodiment of the present disclosure, the first direction X and the second direction Y are perpendicular to each other. In this case, the battery cell 11 can cover the curved photovoltaic module 100 to the maximum extent, and the arrangement of the battery cells 11 can avoid wasting space on the curved photovoltaic module 100, thereby increasing power generation efficiency per unit area. When each battery string 10 covers one crest 101, and the battery cell 11 in each battery string 10 has opposite ends each extending towards the lowest point of the adjacent trough 103, a gap between adjacent battery strings 10 is relatively small, and a plurality of battery strings 10 can spread over almost the entire curved photovoltaic module 100, increasing the power generation efficiency per unit area of the curved photovoltaic module 100.

Referring to FIG. 1 and FIG. 2, in some embodiments, the at least one battery string includes a plurality of battery strings, and two adjacent battery strings 10 are spaced apart from each other by a spacing 13 in the second direction. The spacing 13 has a width in a range of [3 mm, 5 mm]. For example, the width of the spacing 13 may be 3 mm, 3.3 mm, 3.8 mm, 4.2 mm, 4.4 mm, 4.7 mm, 5.1 mm, 5.5 mm, 5.6 mm, or 5 mm, etc.

Since the battery cell 11 is a conductive product, when no spacing 13 is provided between two adjacent battery strings 10 or the width of the spacing 13 is smaller than 3 mm, the battery cells 11 in two adjacent battery strings 10 have contact conduction, resulting in a risk of short circuit between adjacent battery strings 10. When the width of the spacing 13 is greater than 5 mm, the spacing 13 between two adjacent battery strings 10 is too large, which will cause a waste of space on the curved photovoltaic module 100, reducing the power generation efficiency per unit area of the curved photovoltaic module 100. When the width of the spacing 13 ranges from 3 mm to 5 mm, there is no risk of mutual contact and conduction between two adjacent battery strings 10. Moreover, the spacing 13 between two adjacent battery strings 10 is not too large, and there is no waste of space on the curved photovoltaic module 100. In this case, the power generation efficiency per unit area of the curved photovoltaic module 100 is relatively high.

Referring to FIG. 1 and FIG. 2, in some embodiments, when the plurality of battery cells 11 in one battery string 10 are arranged in the first direction X, a difference between the light intensities received by any two battery cells 11 in one battery string 10 is within a predetermined range. The difference between the light intensities received by two battery cells 11 being within the predetermined range means that, in the same period, when any two battery cells 11 in one battery string 10 receive the same or different light intensities respectively, the difference between the currents generated by the two battery cells 11 is within a preset range. For example, the predetermined range may be [0, E], and the preset range may be [0, F]. When the difference between the light intensities received by any two battery cells 11 in one battery string 10 is smaller than E, the difference between the currents generated by the two battery cells 11 is smaller than F. When the difference between the currents generated by any two battery cells 11 in the battery string 10 is greater than F, the difference between the current values generated by the two battery cells 11 is relatively large, and the battery cell 11 with a smaller current will lower the output current of the battery string 10, causing a small output current of the battery string 10. When the difference between the currents generated by any two battery cells 11 in one battery string 10 is smaller than F, the difference between the current values generated by the two battery cells 11 is relatively small, and thus the output current of the battery string 10 is relatively large.

Referring to FIG. 1 and FIG. 2, in some embodiments, the curved photovoltaic module 10 has a ratio of an arc length to a chord length in a range of [1.03, 1.06]. When the curved photovoltaic module 100 is assembled, each battery cell 11 needs to be bent conformally to cover the crest 101 of the curved photovoltaic module 100 and extend towards the lowest point of the trough 103. In this case, the deformation of the battery cell 11 is relatively large. After the battery cell 11 is bent conformally, a ratio of an arc length to a chord length of the battery cell 11 is the same as the ratio of the arc length to the chord length of the curved photovoltaic module 100. When the ratio of the arc length to the chord length of the curved photovoltaic module 100 ranges from 1.03 to 1.06, the battery cell 11 can have a relatively large bendable deformation and is not easily broken.

The arc length of the curved photovoltaic module 100 refers to a linear length L of the curved photovoltaic module 100 in the second direction Y when the curved photovoltaic module 100 is developed. The chord length of the curved photovoltaic module 100 refers to a linear length L of the curved photovoltaic module 100 in the second direction Y when it is bent. The arc length of the battery cell 11 refers to a linear length L of the battery cell 11 in the second direction Y when the battery cell is developed. The chord length of the battery cell 11 refers to a linear length L of the battery cell 11 in the second direction Y when it is bent. For example, the ratio of the arc length to the corresponding chord length of the curved photovoltaic module 100 may be 1.03, 1.034, 1.039, 1.042, 1.045, 1.047, 1.051, 1.054, 1.056, or 1.06, etc.

When the ratio of the arc length to the chord length of the curved photovoltaic module 100 is smaller than 1.03, that is, the ratio of the arc length to the chord length of the battery cell 11 is smaller than 1.03, a bending deformation D of the battery cell 11 is relatively small, and a bending deformation of the curved photovoltaic module 100 is also relatively small. The bending curvature of the curved photovoltaic module 100 is not obvious enough, which is less aesthetically pleasing. When the ratio of the arc length to the chord length of the curved photovoltaic module 100 is greater than 1.06, that is, the ratio of the arc length to the chord length of the battery cell 11 is greater than 1.06, the bending deformation of the battery cell 11 is too large, and the battery cell 11 is likely to be broken. When the ratio of the arc length to the chord length of the curved photovoltaic module 100 ranges from 1.03 to 1.06, that is, the ratio of the arc length to the chord length of the battery cell 11 ranges from 1.03 to 1.06, the battery cell 11 has a relatively large bending deformation and is not easily broken. The curved photovoltaic module 100 has a relatively large bending deformation, has a relatively large bending curvature, and is more aesthetically pleasing.

Referring to FIG. 3 and FIG. 4, in some embodiments, a length L of the battery cell 11 in the second direction Y has a positive correlation with a tolerable deformation D of the battery cell 11 when the battery cell 11 is bent conformally, and a thickness W of the battery cell 11 has a negative correlation with the tolerable deformation D of the battery cell 11 when the battery cell 11 is bent conformally.

In an exemplary embodiment of the present disclosure, a longer length L of the battery cell 11 corresponds to a greater tolerable deformation D of the battery cell 11 when the battery cell 11 is bent conformally, and the battery cell 11 is not easily broken when being bent conformally. For example, there are three battery cells 11 with lengths L of 166 mm, 182 mm, and 210 mm, and the thicknesses W of these three battery cells 11 are the same. In this case, the tolerable deformation D of the battery cell 11 with the length L of 210 mm is greater than the tolerable deformation D of the battery cell 11 with the length L of 182 mm, and the tolerable deformation D of the battery cell 11 with the length L of 182 mm is greater than the tolerable deformation D of the battery cell 11 with the length L of 166 mm.

A thinner thickness W of the battery cell 11 corresponds to a greater tolerable deformation D of the battery cell 11 when the battery cell 11 is bent conformally, and the battery cell 11 is not easily broken when being bent conformally. For example, there are three battery cells 11 with thicknesses W of 190 µm, 170 µm, and 150 µm, and the lengths L of these three battery cells 11 are the same. In this case, the tolerable deformation D of the battery cell 11 with the thickness W of 150 µm is greater than the tolerable deformation D of the battery cell 11 with the thickness W of 170 µm, and the tolerable deformation D of the battery cell 11 with the thickness W of 150 µm is greater than the tolerable deformation D of the battery cell 11 with the thickness W of 190 µm.

Referring to FIG 4, in some embodiments, the curved photovoltaic module 100 further includes a front plate 30, an adhesive film layer 70, and a back plate 50. The front plate 30, the adhesive film layer 70, the battery string 10, the adhesive film layer 70, and the back plate 50 are sequentially stacked. The adhesive film layer 70 is configured to bond the front plate 30 with the battery string 10, and bond the battery string 10 with the back plate 50.

In an exemplary embodiment of the present disclosure, the front plate 30 is disposed at the light-receiving surface 15 of the battery string 10, and is configured to protect the light-receiving surface 15 of the battery string 10. In an embodiment, the front plate 30 has a high light transmittance. For example, the light transmittance may be greater than or equal to 70%, allowing most or even all of the light to pass through the front plate 30 and reach the battery string 10. In this way, the battery string 10 can convert the received light energy into electric energy. For example, the light transmittance of the front plate 30 may be 70%, 73.1%, 75.6%, 77%, 78.5%, 80.3%, 83%, 85.1%, 87.2%, 90.5%, 92.4%, 93.7%, 95.6%, 97.8%, or 100%, etc. The front plate 30 may be a curved rigid front plate 30 or a flexible front plate 30. A material of the front plate 30 may be, but is not limited to, transparent glass or polycarbonate plastic, etc.

The back plate 50 is configured to support and protect the back surface 17 of the battery string 10. In an embodiment, the back plate 50 may have waterproof performance, insulation performance, and weather resistance performance. In this way, the back plate 50 can provide better protection for the back surface 17 of the battery string 10. In an embodiment, the back plate 50 may be a curved rigid back plate 50. In this case, the back plate 50 may be tempered glass or semi-tempered glass, etc. The back plate 50 has a high strength and can provide good support and protection for the battery string 10. In another embodiment, the back plate 50 may be a flexible back plate 50. The flexible back plate 50 may be bent conformally with the curved front plate 30 to form the same curved surface as the front plate 30. In this case, a material of the back plate 50 may be, but is not limited to, polyethylene terephthalate (PET) or a composite material of PET, etc. The back plate 50 has a relatively light weight and good bending performance.

The adhesive film layer 70 is configured to bond two other elements to make the elements closely connected. For example, the adhesive film layer 70 may be configured to bond the front plate 30 with the battery string 10, and bond the battery string 10 with the back plate 50, etc. A material of the adhesive film layer 70 may be Ethylene Vinyl Acetate (EVA), Poly Olefin Elastomer (POE), Polyvinyl butyral (PVB), or Thermoplastic Elastomer (TPO), etc. In this case, the adhesive film layer 70 has a relatively high light transmittance. When the light passes through the adhesive film layer 70 and reaches the battery string 10, a loss of light through the adhesive film layer 70 is relatively small, and thus the battery has a relatively high utilization rate of the light. For example, the light transmittance of the adhesive film layer 70 may be greater than or equal to 70%, and the light transmittance of the adhesive film layer 70 may be 70%, 75.2%, 79.5%, 82.1%, 86.3%, 88.2%, 93.1%, 94.2%, 98.5%, or 100%, etc.

Referring to FIG 1 to FIG. 4, in some embodiments, the battery string 10 is bent conformally with the front plate 30, and an arch height of the front plate 30 is smaller than or equal to a maximum tolerable deformation of the battery cell 11 when the battery cell 11 is bent conformally. In this case, the front plate 30 is a curved rigid front plate 30. When the curved photovoltaic module 100 is assembled, the light-receiving surface 15 of the battery string 10 is attached to the front plate 30, and the battery string 10 may be bent conformally with the front plate 30 to form the same curved surface as the front plate 30. When the battery string 10 is bent conformally with the front plate 30, an arch height H of the front plate 30 is the same as the deformation of the battery cell 11. When the arch height H of the front plate 30 is smaller than or equal to the maximum tolerable deformation of the battery cell 11, and when the battery cell 11 is bent conformally with the front plate 30, the battery cell 11 will not suffer from cracking. For example, the maximum tolerable deformation of the battery cell 11 when the battery cell 11 is bent conformally is D1, and the arch height H of the front plate 30 is smaller than D1, the deformation that the battery cell 11 is bent conformally with the front plate 30 is D. The deformation D of the battery cell 11 is equal to the arch height H of the front plate 30. Therefore, the deformation D of the battery cell 11 is smaller than the maximum tolerable deformation D1 of the battery cell 11 when the battery cell 11 is bent conformally, and the battery cell 11 will not suffer from cracking when being bent conformally.

Referring to FIG 1 to FIG. 4, in some other embodiments, the battery string 10 is bent conformally with the back plate 50, and an arch height of the back plate 50 is smaller than or equal to a maximum tolerable deformation of the battery cell 11 when the battery cell 11 is bent conformally. In this case, the back plate 50 is a curved rigid back plate 50. When the curved photovoltaic module 100 is assembled, the back surface 17 of the battery string 10 is attached to the back plate 50, and the battery string 10 may be bent conformally with the back plate 50 to form the same curved structure as the back plate 50. When the battery string 10 is bent conformally with the back plate 50, an arch height H of the back plate 50 is the same as the deformation of the battery cell 11. When the arch height of the back plate 50 is smaller than or equal to the maximum tolerable deformation of the battery cell 11, and the battery cell 11 is bent conformally with the back plate 50, the battery cell 11 will not suffer from cracking. For example, the maximum tolerable deformation of the battery cell 11 when the battery cell 11 is bent conformally is D1. When the arch height H of the back plate 50 is smaller than D1, the deformation of the battery cell 11 when being bent conformally with the back plate 50 is D. The deformation D of the battery cell 11 is equal to the arch height H of the back plate 50. Therefore, the deformation D of the battery cell 11 is smaller than the maximum tolerable deformation D1 of the battery cell 11 when the battery cell 11 is bent conformally, and the battery cell 11 will not suffer from cracking when being bent conformally.

Referring to FIG 1 to FIG. 4, in some further embodiments, the battery string 10 is bent conformally with the front plate 30, and the arch height of the front plate 30 is smaller than or equal to the maximum tolerable deformation of the battery cell 11 when the battery cell 11 is bent conformally. The battery string 10 is also bent conformally with the back plate 50, and the arch height of the back plate 50 is smaller than or equal to the maximum tolerable deformation of the battery cell 11 when the battery cell 11 is bent conformally. In this case, both the front plate 30 and the back plate 50 are curved rigid back plates 50. When the curved photovoltaic module 100 is assembled, the light-receiving surface 15 of the battery string 10 is attached to the front plate 30, the back surface 17 of the battery string 10 is attached to the back plate 50, and the battery string 10 may be bent conformally with both the front plate 30 and the back plate 50 to form the same curved structure as both the front plate 30 and the back plate 50. When the battery string 10 is bent conformally with both the front plate 30 and the back plate 50, the arch height of the front plate 30, the arch height of the back plate 50, and the deformation of the battery cell 11 are the same. When both the arch height of the front plate 30 and the arch height of the back plate 50 are smaller than or equal to the maximum tolerable deformation of the battery cell 11, and when the battery cell 11 is bent conformally with both the front plate 30 and the back plate 50, the battery cell 11 will not suffer from cracking. For example, the maximum tolerable deformation of the battery cell 11 when the battery cell 11 is bent conformally is D1, the arch height of the front plate 30 is H1, and the arch height of the back plate 50 is H2. When both the arch height H1 of the front plate 30 and the arch height H2 of the back plate 50 are smaller than D1, the deformation of the battery cell 11 when the battery cell 11 is bent conformally with both the front plate 30 and the back plate 50 is D. The deformation D of the battery cell 11 is equal to the arch height H1 of the front plate 30, and the deformation D of the battery cell 11 is equal to the arch height H2 of the back plate 50. Therefore, the deformation D of the battery cell 11 is smaller than the maximum tolerable deformation D1 of the battery cell 11 when the battery cell 11 is bent conformally, and the battery cell 11 will not suffer from cracking when being bent conformally.

Referring to FIG. 5, a photovoltaic building surface 1000 according to an embodiment of the present disclosure includes a plurality of curved photovoltaic modules 100 of the above embodiments, and the plurality of curved photovoltaic modules 100 is connected to each other.

In the photovoltaic building surface 1000 of the embodiment of the present disclosure, the plurality of battery cells 11 of the battery string 10 is arranged in the first direction X of the curved photovoltaic module 100. Each battery cell 11 in the battery string 10 covers a corresponding crest 101, and is symmetrically arranged about the axis of the corresponding crest 101 that extends in the first direction X. Therefore, light intensities received by the plurality of battery cells 11 are substantially the same in the same period, and the current outputted by the battery string 10 is relatively large. Compared with the existing curved photovoltaic module 100, since the light intensities received by the plurality of battery cells 11 in the battery string 10 of the present disclosure are subsstantially the same, the problem that the battery cell 11 receiving the small light intensity in the battery string 10 generates small current and this battery cell 11 lowers the output current of the battery string 10 can be avoided.

The respective technical features described in the above embodiments can be arbitrarily combined with each other. For a brief description, all possible combinations of these technical features in the foregoing embodiments are not described individually. However, any combination of these technical features shall fall within the scope of the present disclosure, unless they are contradictory. In addition, other embodiments can be derived from the above embodiments, thus structural and logical substitutions and changes can be made without departing from the scope of the present disclosure.

The above embodiments described in detail illustrate merely some implementations of the present disclosure, and shall not be regarded as limitations to the scope of the present disclosure. It should be pointed out that, those skilled in the art, without departing from the concept of the present disclosure, can make various changes and improvements, which shall fall within the protection scope of the present disclosure. Therefore, the protection scope of the present disclosure is defined by the appended claims.

## Claims

1. A curved photovoltaic module, comprising:
at least one battery string, each of the at least one battery string comprising a plurality of battery cells connected in series and arranged in a first direction of the curved photovoltaic module,
wherein the curved photovoltaic module has at least one crest and at least one trough, wherein in the first direction, each of the plurality of battery cells in each of the at least one battery string covers a corresponding crest of the at least one crest and is symmetrically arranged about an axis of the corresponding crest that extends in the first direction.

2. The curved photovoltaic module according to claim 1, wherein in a second direction, each of the plurality of battery cells has opposite ends each extending towards a lowest point of an adjacent trough of the at least one trough, the second direction being an extending direction of a tangent at a highest point of the corresponding crest, and the second direction intersecting with the first direction.

3. The curved photovoltaic module according to claim 2, wherein the at least one battery string comprises a plurality of battery strings, and two adjacent battery strings of the plurality of battery strings are spaced apart from each other by a spacing in the second direction, the spacing having a width in a range of [3 mm, 5 mm].

4. The curved photovoltaic module according to claim 1, wherein a difference in light intensities received by any two of the plurality of battery cells in each of the at least one battery string is within a predetermined range.

5. The curved photovoltaic module according to claim 1, wherein the curved photovoltaic module has a ratio of an arc length to a chord length in a range of [1.03, 1.06].

6. The curved photovoltaic module according to claim 2, wherein:
a length of each of the plurality of battery cells in the second direction has a positive correlation with a tolerable deformation of the battery cell when the battery cell is bent conformally; and/or
a thickness of each of the plurality of battery cells has a negative correlation with the tolerable deformation of the battery cell when the battery cell is bent conformally.

7. The curved photovoltaic module according to claim 1, further comprising a front plate and a back plate, wherein the front plate, the at least one battery string, and the back plate are sequentially stacked.

8. The curved photovoltaic module according to claim 7, wherein:
the front plate is a curved front plate, wherein the at least one battery string is bent conformally with the front plate, and wherein an arch height of the front plate is smaller than or equal to a maximum tolerable deformation of the battery cell when the battery cell is bent conformally; and/or
the back plate is a curved back plate, wherein the at least one battery string is bent conformally with the back plate, and wherein an arch height of the back plate is smaller than or equal to a maximum tolerable deformation of the battery cell when the battery cell is bent conformally.

9. The curved photovoltaic module according to claim 7, further comprising an adhesive film layer configured to bond the front plate with the at least one battery string and bond the at least one battery string with the back plate.

10. A photovoltaic building surface, comprising a curved photovoltaic module, wherein the curved photovoltaic module comprises:
at least one battery string, each of the at least one battery string comprising a plurality of battery cells connected in series and arranged in a first direction of the curved photovoltaic module,
wherein the curved photovoltaic module has at least one crest and at least one trough, wherein in the first direction, each of the plurality of battery cells in each of the at least one battery string covers a corresponding crest of the at least one crest and is symmetrically arranged about an axis of the corresponding crest that extends in the first direction.

11. The photovoltaic building surface according to claim 10, wherein in a second direction, each of the plurality of battery cells has opposite ends each extending towards a lowest point of an adjacent trough of the at least one trough, the second direction being an extending direction of a tangent at a highest point of the corresponding crest, and the second direction intersecting with the first direction.

12. The photovoltaic building surface according to claim 11, wherein the at least one battery string comprises a plurality of battery strings, and two adjacent battery strings of the plurality of battery strings are spaced apart from each other by a spacing in the second direction, the spacing having a width in a range of [3 mm, 5 mm].

13. The photovoltaic building surface according to claim 10, wherein a difference in light intensities received by any two of the plurality of battery cells in each of the at least one battery string is within a predetermined range.

14. The photovoltaic building surface according to claim 10, wherein the curved photovoltaic module has a ratio of an arc length to a chord length in a range of [1.03, 1.06].

15. The photovoltaic building surface according to claim 11, wherein:
a length of each of the plurality of battery cells in the second direction has a positive correlation with a tolerable deformation of the battery cell when the battery cell is bent conformally; and/or
a thickness of each of the plurality of battery cells has a negative correlation with the tolerable deformation of the battery cell when the battery cell is bent conformally.

16. The photovoltaic building surface according to claim 10, further comprising a front plate and a back plate, wherein the front plate, the at least one battery string, and the back plate are sequentially stacked.

17. The photovoltaic building surface according to claim 16, wherein:
the front plate is a curved front plate, wherein the at least one battery string is bent conformally with the front plate, and wherein an arch height of the front plate is smaller than or equal to a maximum tolerable deformation of the battery cell when the battery cell is bent conformally; and/or
the back plate is a curved back plate, wherein the at least one battery string is bent conformally with the back plate, and wherein an arch height of the back plate is smaller than or equal to a maximum tolerable deformation of the battery cell when the battery cell is bent conformally.

18. The photovoltaic building surface according to claim 16, further comprising an adhesive film layer configured to bond the front plate with the at least one battery string and bond the at least one battery string with the back plate.
